(19) Europäisches Patentamt
European Patent Office
Office européen des brevets

(11) Veröffentlichungsnummer: **0 210 374**
**B1**

(12) # EUROPÄISCHE PATENTSCHRIFT

(45) Veröffentlichungstag der Patentschrift: **10.05.89**

(51) Int. Cl.[4]: **G01N 24/08**

(21) Anmeldenummer: **86107288.2**

(22) Anmeldetag: **28.05.86**

(54) **Kernspintomographiegerät.**

(30) Priorität: **11.06.85 DE 3520900**

(43) Veröffentlichungstag der Anmeldung:
**04.02.87 Patentblatt 87/6**

(45) Bekanntmachung des Hinweises auf die Patenterteilung:
**10.05.89 Patentblatt 89/19**

(84) Benannte Vertragsstaaten:
**DE FR GB**

(56) Entgegenhaltungen:
**EP-A- 0 093 897**
**EP-A- 0 096 487**
**EP-A- 0 117 725**
**EP-A- 0 132 975**
**EP-A- 0 155 052**
**EP-A- 0 172 345**

**AMERICAN JOURNAL OF RADIOLOGY, Band 143, Dezember 1984, Seiten 1175-1182, American Roentgen Ray Society, New York, US; R.L. EHMAN et al.: "Magnetic resonance imaging with respiratory gating: techniques and advantages"**

(73) Patentinhaber: **Siemens Aktiengesellschaft Berlin und München, Wittelsbacherplatz 2, D-8000 München 2(DE)**

(72) Erfinder: **Zimmermann, Bernd-Hellmut, Dr.-Phys., Erlanger Strasse 46, D-8551 Röttenbach(DE)**
Erfinder: **Czygan, Peter, Kronacher Strasse 7, D-8500 Nürnberg(DE)**

**EP 0 210 374 B1**

Anmerkung: Innerhalb von neun Monaten nach der Bekanntmachung des Hinweises auf die Erteilung des europäischen Patents im Europäischen Patentblatt kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

**Beschreibung**

Die Erfindung betrifft ein Kernspintomographiegerät, bei dem Mittel zum Anlegen von magnetischen Grund- und Gradientenfeldern an das Untersuchungsobjekt und zum Erfassen der Auslenkung der Kernspins des Untersuchungsobjektes aus ihrer Gleichgewichtslage durch einen hochfrequenten magnetischen Anregungsimpuls vorhanden sind, wobei bei einer Vielzahl von Gradienten in einer Schicht des Untersuchungsobjektes jeweils eine Projektion der Kernspins auf eine Frequenzachse als Fourierzeile erfaßt und aus den Fourierzeilen ein Bild der jeweils untersuchten Schicht durch Fouriertransformation berechnet wird und wobei Mittel zur Steuerung der Erfassung der Fourierzeilen in Abhängigkeit von einem Bewegungssignal vorgesehen sind.

Es ist bekannt, daß man insbesondere die Wasserstoffkernspins eines Untersuchungsobjektes aus einer Vorzugsrichtung, die durch ein Magnet-Grundfeld erzeugt wird, durch einen hochfrequenten Anregungsimpuls auslenken kann und daß diese Spins nach dem Ende dieses Anregungsimpulses erst nach einer gewissen Zeit wieder in die Vorzugsrichtung einpendeln. Während dieser Zeit präzessieren die Spins mit einer Frequenz, die von Stärke des Magnet-Grundfeldes abhängt. Diese Präzessionsbewegung kann mit einer HF-Antenne und entsprechenden Empfängerschaltungen detektiert werden. Überlagert man diesem homogenen Magnet-Grundfeld einen ersten Feldgradienten, so daß die Magnetfeldverteilung räumlich variiert, so ist eine Ortung der Spins in einer Raumrichtung, nämlich der Gradientenrichtung, über die jeweils gemessene Frequenz möglich.

Es ist auch bekannt, daß man durch kurzzeitiges Anlegen eines zum ersten Gradienten orthogonalen zweiten Gradienten variabler Amplitude oder Zeitdauer eine Ortskodierung in einer zweiten Raumachse vornehmen kann, bevor die Signale im ersten Gradienten ausgelesen werden und auf diese Weise Schichtbilder eines Untersuchungsobjektes anfertigen kann. Die Anregung in einer Schicht des Untersuchungsobjektes erfolgt dabei dadurch, daß das Magnet-Grundfeld durch einen weiteren dritten Feldgradienten senkrecht zum ersten und zweiten Gradienten so beeinflußt wird, daß nur in dieser Schicht eine Anregung der Spins erfolgt. Dies ist möglich, weil die Anregung nur mit einer Frequenz erfolgt, die dem Magnetfeld in der gewünschten Schicht streng zugeordnet ist. Dieses Verfahren ist z.B. in der DE-OS 2 611 497 beschrieben.

Aufgrund der Vielzahl der erforderlichen Meßvorgänge dauert eine vollständige Messung für eine Schicht so lange, daß sich Bewegungen im Untersuchungsobjekt, beispielsweise Bewegungen aufgrund des Herzschlages oder der Atmung, als Störungen im erzeugten Bild zeigen würden. Zur Vermeidung solcher Störungen ist es bekannt, die Meßwerterfassung in Abhängigkeit vom EKG und von der jeweiligen Atemphase zu steuern. Bei der Atemphasensteuerung wird die Meßwerterfassung nur in einem relativ kurzen Zeitbereich jeder Atemphase freigegeben. Dadurch ergibt sich jedoch eine erhebliche Verlängerung der Meßzeit, die in der Praxis nicht immer akzeptierbar ist.

Der Erfindung liegt die Aufgabe zugrunde, ein Gerät der eingangs genannten Art so auszubilden, daß durch Bewegungen, insbesondere Atembewegungen, erzeugte Bewegungsartefakte im Bild auf ein Minimum reduziert sind, wobei die Meßzeit gegenüber dem Stand der Technik erheblich verkleinert ist.

Diese Aufgabe ist erfindungsgemäß dadurch gelöst, daß eine Steuervorrichtung vorhanden ist, die die Einordnung der Fourierzeilen in die Meßmatrix in der Weise steuert, daß Fourierzeilen, bei denen das Bewegungssignal einen vorbestimmten Wert überschreitet, von der Mitte der Meßmatrix aus und die restlichen Fourierzeilen vom Rand aus in die Meßmatrix eingeordnet werden. Bei dem erfindungsgemäßen Kernspintomographiegerät erfolgt durch Setzen einer Schwelle eine Unterscheidung der Fourierzeilen, die in Abhängigkeit vom Auftreten in bezug auf das Bewegungssignal in die Meßmatrix eingeordnet werden. Der gesamte Meßvorgang dauert dabei nicht länger als bei Kernspintomographiegeräten, bei denen keine Bewegungsphasensteuerung erfolgt. Die Bildqualität ist dabei demgegenüber erheblich verbessert.

Die Erfindung ist nachfolgend anhand der Zeichnung näher erläutert. Es zeigen:

Fig. 1 eine Darstellung eines Gerätes nach der Erfindung, und

Fig. 2 bis 4 Darstellungen zur Erläuterung der Wirkungsweise des Gerätes gemäß Figur 1.

In der Figur 1 ist eine Auflage 1 dargestellt, auf der ein Patient 2 liegt, von dem mit Hilfe magnetischer Kernresonanz Bilder erzeugt werden sollen. Hierzu ist ein Spulensystem 3 mit einer Spule 4 zur Erzeugung eines homogenen Magnet-Grundfeldes, Gradientenspulen 5 zur Variierung dieses Magnet-Grundfeldes sowie mit einer Anregungs- und Meßspule 7 vorhanden. Die Spule 4 ist an einer Magnet-Stromversorgung 8, die Gradientenspulen 5 sind an einer Gradienten-Stromversorgung 9, die Anregungs- und Meßspule 7 ist an einem Vorverstärker 10 und über entsprechende Koppelelemente an einem Sendeverstärker 11 angeschlossen. Der Vorverstärker 10 führt das Meßsignal über einen phasenempfindlichen Gleichrichter 12 einem Prozeßrechner 13 zu, der den gesamten Meßvorgang steuert. Zur Erzeugung eines Anregungsimpulses dient ein Hochfrequenzoszillator 14, der über einen Modulator 15 an den Sendeverstärker 11 anschaltbar ist. Die Wiedergabe der aus den Meßsignalen rekonstruierten Bilder erfolgt auf einem Monitor 16.

Zur Erzeugung eines Schichtbildes von dem im Spulensystem 3 gelagerten Patienten 2 werden zunächst die Spins in der gewünschten Schicht angeregt.

Die Figur 2 zeigt, daß die jeweils angeregte Schicht im Patienten 2 von der Ortsabhängigkeit der Flußdichte und damit der Kernresonanzfrequenz bestimmt wird. Der Feldgradient für das Grundfeld ist in der Figur 2 schematisch dargestellt

und mit 17 bezeichnet. Die Resonanzfrequenz ist mit f bezeichnet. Es erfolgt dabei nur eine Anregung der Spins im dargestellten Bereich des Patienten 2.

Nach der Anregung erfolgt die Kodierung der Spins in der (wie oben) bezeichneten zweiten Raumachse durch Anlegen eines kurzzeitigen Gradienten in der zweiten Raumrichtung, im folgenden Kodiergradient genannt. Anschließend wird das Kernresonanzsignal in dem die erste Raumdimension definierenden sogenannten Auslesegradienten abgetastet. Dieser Vorgang wird z.B. mit schrittweise von positiv nach negativ verändertem Kodiergradienten wiederholt. Die zu einer bestimmten Kodiergradientenamplitude ausgelesenen Kernresonanzsignale kann man als Fourierprojektion bezeichnen.

Die den aufeinanderfolgenden Fourierprojektionen entsprechenden Meßsignale entsprechen parallelen Fourierzeilen der in der Figur 3 dargestellten Meßmatrix 21. In der Praxis können beispielsweise für eine vollständige Meßmatrix 256 Fourierzeilen vorgesehen werden, wobei die Fourier-Nullzeile 20, die zum Kodiergradienten der Amplitude 0 gehört, in der Mitte der Meßmatrix 21 gemäß Figur 3 liegt. Durch zweidimensionale Fouriertransformation nach Zeilen und Spalten kann aus den Meßsignalen der einzelnen Fourierzeilen ein Bild der untersuchten Schicht berechnet werden.

Erfolgt die Meßsignalerfassung ununterbrochen, so ergeben sich störende Bewegungsartefakte im erzeugten Bild. Es ist deshalb bekannt, die Atemkurve des Patienten 2 mit einem Meßaufnehmer zu registrieren und das Atemsignal mit Hilfe einer Elektronik so aufzubereiten, daß Meßsignale nur in einem bestimmten Zeitintervall jeder Atemphase aufgenommen werden können, alle anderen Messungen, die außerhalb dieses Intervalles anfallen, werden verworfen. Um eine möglichst geringe Bewegungsunschärfe in den Bildern zu haben, muß das Zeitintervall möglichst kurz sein. Dadurch verlängert sich die Meßzeit gegenüber dem Fall der nicht atemgetriggerten Meßsignalerfassung jedoch drastisch.

Für eine Matrix mit 256 Zeilen müssen mindestens 256 Einzelaufnahmen gemacht werden. Der Kodiergradient kann bei einer atemphasengesteuerten Messung nur nach einer Messung im Frei-Zustand fortgeschaltet werden, denn die nicht im Frei-Zustand erfolgten Messungen werden verworfen.

Der Erfindung liegt nun die Erkenntnis zugrunde, daß eine praktisch vollständige Unterdrückung von atembedingten Bewegungsartefakten im erzeugten Bild auch möglich ist, wenn die Fourierzeilen in der Weise in die Meßmatrix 21 eingeordnet werden, daß Fourierzeilen, bei denen das Atemsignal einen vorbestimmten Wert überschreitet, von der Mitte der Meßmatrix 21 aus und die restlichen Fourierzeilen vom Rand aus wechselweise oberhalb und unterhalb der Mitte der Meßmatrix 21 eingeordnet werden. Dadurch wird bei von Bewegungen des Patienten weitgehend unbeeinflußter Bildqualität die Meßzeit gegenüber dem Fall der dauernden Meßsignalerfassung nicht verlängert.

Zur atemphasengesteuerten Meßsignalerfassung ist dem Patienten 7 ein Atemdetektor 22 zugeordnet, der auf der Leitung 23a ein von einer Aufbereitungsstufe 23 erzeugtes Atemphasensignal bildet. Als Atemdetektor kann auch ein Dehnungsband um die Brust des Patienten oder ein anderer Detektor vorgesehen sein, der die Atembewegung der Lungen und damit die Bewegung des Brustkorbes und Oberbauchbereiches erfaßt. Dieses Atemphasensignal verläuft beispielsweise gemäß Figur 4. Es ist einer Steuervorrichtung 24 zugeführt, die die Einordnung der Fourierzeilen in die Meßmatrix 21 in der oben beschriebenen und nachfolgend noch näher erläuterten Weise steuert.

Aus der Figur 4 geht hervor, daß dem Atemphasensignal 25 eine Schwelle 26 zugeordnet ist. Ferner sind beispielsweise Zeitpunkte A bis M eingezeichnet, während denen die Bildung von Fourierzeilen erfolgt. Die entsprechenden Fourierzeilen werden gemäß Figur 3 in der Weise in die Meßmatrix 21 eingeordnet, daß Fourierzeilen, die entstehen, wenn das Atemphasensignal über der Schwelle 26 liegt, von der Nullzeile 20 aus wechselweise oben und unten und Fourierzeilen, die entstehen, wenn das Atemphasensignal 25 unter der Schwelle 26 liegt, vom Rand der Meßmatrix 21 aus wechselweise zur Mitte hin in diese eingeordnet werden. Demgemäß erfolgt zunächst von der Nullzeile 20 aus die Einordnung der Fourierzeilen a bis c, die den Zeitpunkten A bis C in Figur 4 zugeordnet sind, anschließend vom Rand aus die Einordnung der Fourierzeilen d bis i, die den Zeitpunkten D bis I in Figur 4 zugeordnet sind, weiter die Einordnung der Fourierzeilen k, l, m, die den Zeitpunkten K, L, M in Figur 4 zugeordnet ist, wieder von der Nullzeile aus usw. Die gesamte Meßzeit ist dabei gegenüber dem Fall, in dem keine atemphasengesteuerte Einordnung der Fourierzeilen in die Meßmatrix erfolgt, nicht verlängert.

Durch die beschriebene Einordnung der Fourierzeilen in die Meßmatrix 21 ist erreicht, daß diejenigen Fourierzeilen, die atemphasengesteuert erzeugt werden, um die Nullzeile 20 herum in der Meßmatrix 21 liegen, so daß die Bildqualität durch diejenigen Fourierzeilen, die nicht atemphasengesteuert erfaßt werden, praktisch nicht verschlechtert wird, weil diese in die Meßmatrix 21 zu den Rändern hin eingeordnet werden. Damit eine gewünschte Bildqualität nicht unterschritten wird, ist es sinnvoll, die Einordnung der Fourierzeilen vom Rand aus zu beenden, wenn eine bestimmte Zeilengrenze erreicht wird, die in der Figur 3 mit 27, 28 bezeichnet ist. Wird diese Zeilengrenze erreicht, so werden die darauffolgenden Fourierzeilen nur noch von der Nullzeile 20 aus aufeinanderfolgend oben und unten in die Meßmatrix 21 eingeordnet.

Sowohl die Schwelle 26 als auch die Lage der Zeilengrenze 27 und 28 können einstellbar sein. Da die Bewegungsunschärfe im erzeugten Bild von der zeitlichen ($\Delta t$) Änderung des Brustraumvolumens ($\Delta V$) abhängig ist, ist es sinnvoll, die Schwelle 26 abhängig von einer möglichst geringen Änderung

$$\frac{\Delta V}{\Delta t}$$

zu legen. Die Schwelle 26 selbst muß generell festgelegt werden, um eine einwandfreie räumliche Zuordnung der Meßwerte zu erhalten.

**Patentansprüche**

1. Kernspintomographiegerät, bei dem Mittel (3) zum Anlegen von magnetischen Grund- und Gradientenfeldern an das Untersuchungsobjekt (2) und zum Erfassen der Auslenkung der Kernspins des Untersuchungsobjektes (2) aus ihrer Gleichgewichtslage durch einen hochfrequenten magnetischen Anregungsimpuls vorhanden sind, wobei bei einer Vielzahl von Gradienten in einer Schicht des Untersuchungsobjektes (2) jeweils eine Projektion der Kernspins auf eine Frequenzachse als Fourierzeile erfaßt und aus den Fourierzeilen ein Bild der jeweils untersuchten Schicht durch Fouriertransformation berechnet wird und wobei Mittel (22, 23, 24) zur Steuerung der Erfassung der Fourierzeilen in Abhängigkeit von einem Bewegungssignal vorgesehen sind, dadurch gekennzeichnet, daß eine Steuervorrichtung (24) vorhanden ist, die die Einordnung der Fourierzeilen (a bis m usw.) in die Meßmatrix (21) in der Weise steuert, daß Fourierzeilen (a, b, c, k, l, m usw.), bei denen das Bewegungssignal einen vorbestimmten Wert (26) überschreitet, von der Mitte (20) der Meßmatrix (21) aus und die restlichen Fourierzeilen (d bis i usw.) vom Rand aus in die Meßmatrix (21) eingeordnet werden.

2. Kernspintomographiegerät nach Anspruch 1, dadurch gekennzeichnet, daß die Steuervorrichtung (24) derart ausgebildet ist, daß die Fourierzeilen (a bis m usw.) aufeinanderfolgend wechselweise oberhalb und unterhalb der Mitte (20) der Meßmatrix (21) eingeordnet werden.

3. Kernspintomographiegerät nach Anspruch 1 oder 2, dadurch gekennzeichnet, daß eine Zeilengrenze (27, 28) programmierbar ist, bei der die Einordnung der Fourierzeilen (d bis i usw.) vom Rand aus beendet wird und nachfolgende Fourierzeilen nur noch von der Mitte (20) aus eingeordnet werden.

**Claims**

1. Nuclear spin tomography apparatus, in which there are means (3) for applying magnetic base and gradient fields to the examination subject (2) and for detecting the deflection of the nuclear spin of the examination subject (2) out of its state of equilibrium by means of a high-frequency magnetic excitation impulse, where, with a plurality of gradients in one layer of the examination subject (2), a projection of the nuclear spin onto a frequency axis is detected for each one as a Fourier line and from the Fourier lines an image of the respectively examined layer is calculated by means of Fourier transform, and where means (22, 23, 24) are provided for the control of the detection of the Fourier lines as a function of a movement signal, characterised in that there is provided a control device (24) which controls the arrangement of the Fourier lines (a to m etc.) into the measuring matrix (21) in such a way that Fourier lines (a, b, c, k, l, m etc.), at which the movement signal exceeds a predetermined value (26), are arranged from the centre (20) of the measuring matrix (21) outwards and the remaining Fourier lines (d to i etc.) are arranged from the edge into the measuring matrix (21).

2. Nuclear spin tomography apparatus according to claim 1, characterised in that the control device (24) is developed such that the Fourier lines (a to m etc.) are arranged successively alternately above and below the centre (20) of the measuring matrix (21).

3. Nuclear spin tomography apparatus according to claim 1 or 2, characterised in that it is possible to program a line limit (27, 28) at which the arrangement of the Fourier lines (d to i etc.) is terminated from the edge and consecutive Fourier lines are only arranged from the centre (20) outwards.

**Revendications**

1. Appareil de tomographie à spin nucléaire, dans lequel il est prévu des moyens (3) pour appliquer un champ magnétique de base et des champs magnétiques irrotationnels au sujet d'examen (2) et détecter la déviation des spins nucléaires du sujet examiné (2) à partir de leur position d'équilibre, à l'aide d'une impulsion d'excitation magnétique à haute fréquence, et dans lequel dans le cas d'une multiplicité de gradients dans une couche du sujet examiné (2), une projection des spins nucléaires sur un axe des fréquences est détectée respectivement sous la forme d'une ligne de Fourier et une image de la couche respectivement examinée est calculée à partir des lignes de Fourier par une transformation de Fourier, et dans lequel il est prévu des moyens (22, 23, 24) pour commander la détection des lignes de Fourier en fonction d'un signal de déplacement, caractérisé par le fait qu'il est prévu un dispositif de commande (24), qui commande le rangement des lignes de Fourier (a à m, etc.) dans la matrice de mesure (21) de manière que les lignes de Fourier (a, b, c, k, l, m etc.), dans lesquelles le signal de déplacement dépasse une valeur prédéterminée (26), sont rangées à partir du centre (20) de la matrice de mesure, (21) et que les autres lignes de Fourier (d à i, etc.) sont rangées à partir du bord dans la matrice de mesure (21).

2. Appareil de tomographie à spin nucléaire suivant la revendication 1, caractérisé par le fait que le dispositif de commande (24) est agencé de telle sorte que les lignes de Fourier (a à m, etc.) sont rangées successivement en alternance au-dessus et au-dessous du centre (20) de la matrice de mesure (21).

3. Appareil de tomographie à spin nucléaire suivant la revendication 1 ou 2, caractérisé par le fait qu'il est possible de programmer une limite (27, 28) des lignes, au niveau de laquelle le rangement des lignes de Fourier (d à i, etc.) à partir du bord est terminé et des lignes suivantes de Fourier sont encore rangées uniquement à partir du centre (20).

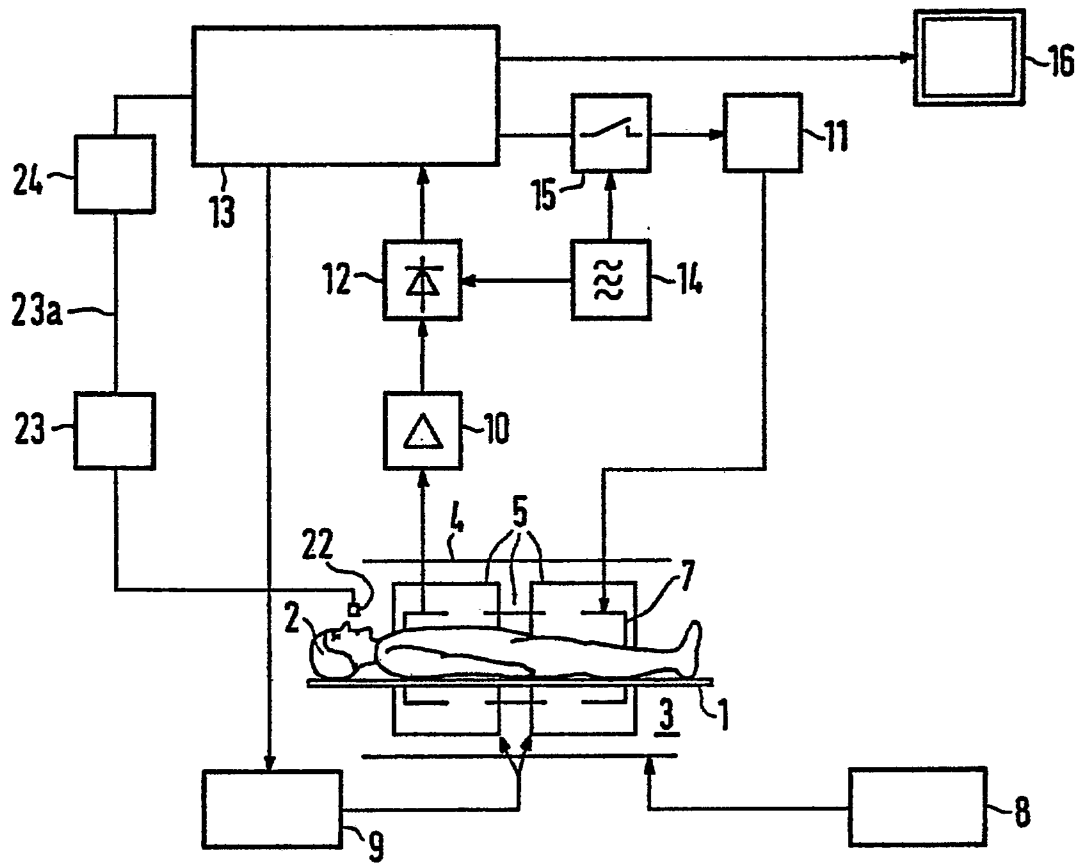


FIG 1

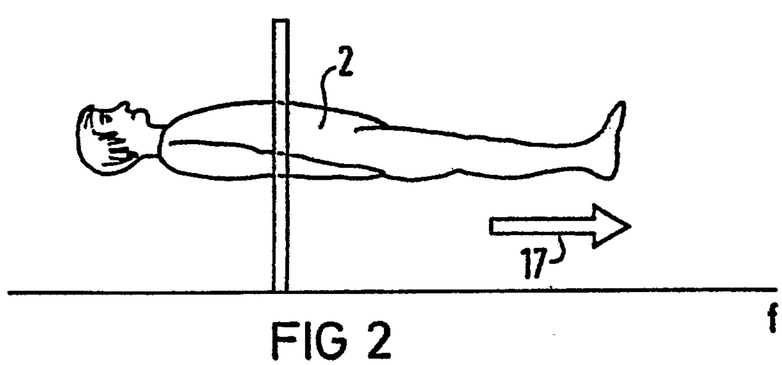


FIG 2

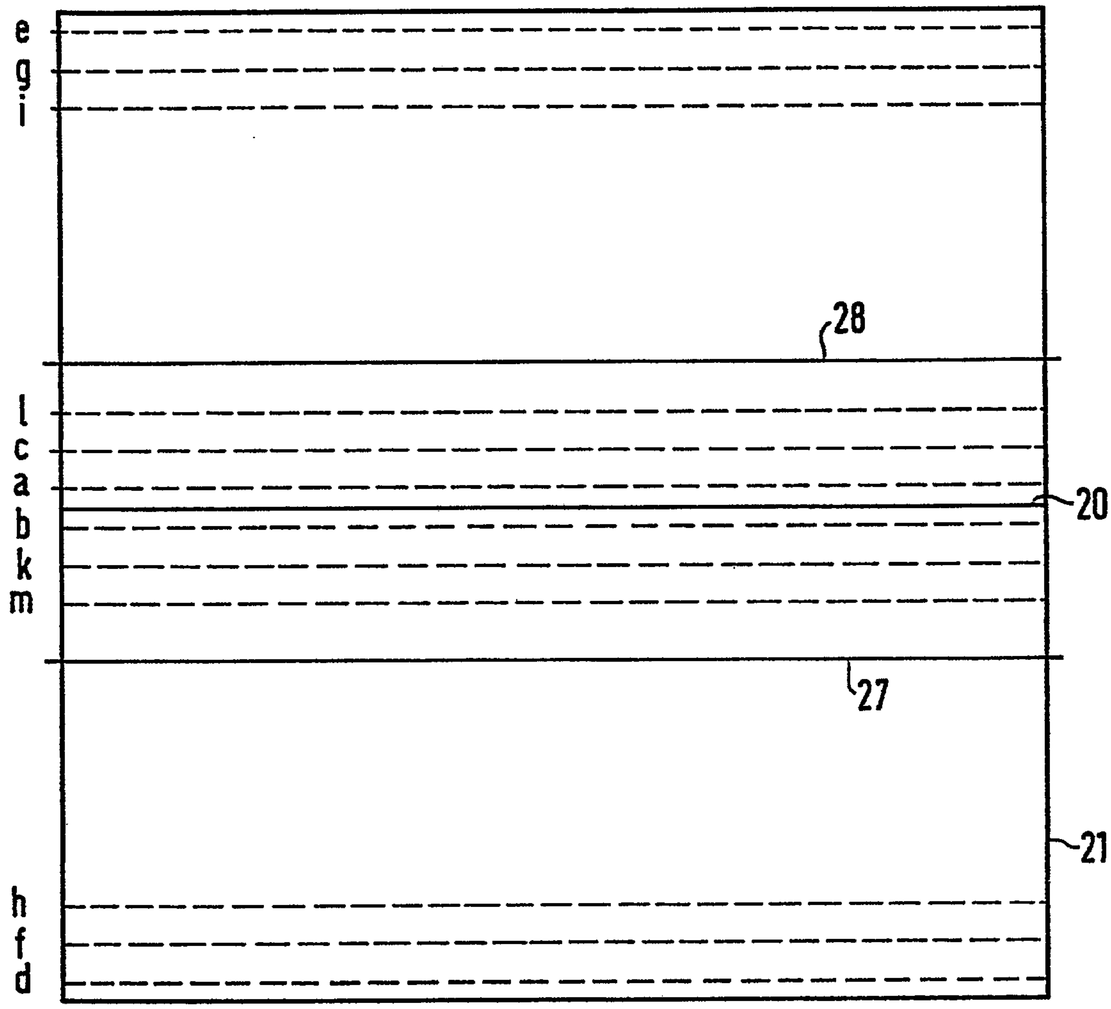


FIG 3

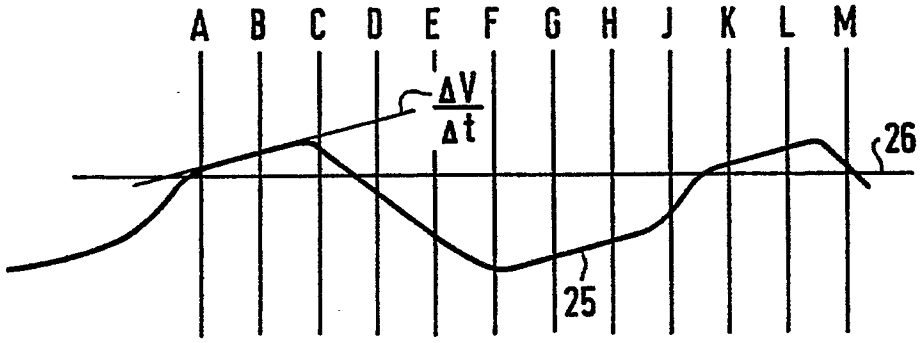


FIG 4